(19) Europäisches Patentamt
European Patent Office
Office européen des brevets

(11) **EP 3 321 392 A1**

(12) **EUROPEAN PATENT APPLICATION**
published in accordance with Art. 153(4) EPC

(43) Date of publication:
**16.05.2018 Bulletin 2018/20**

(21) Application number: **15898396.5**

(22) Date of filing: **23.12.2015**

(51) Int Cl.:
*C23C 28/00* (2006.01)    *C23C 22/60* (2006.01)
*C23C 22/64* (2006.01)    *C23C 14/06* (2006.01)
*C23C 14/34* (2006.01)    *C23C 14/22* (2006.01)
*C23C 14/32* (2006.01)    *C23C 16/26* (2006.01)
*C22C 23/00* (2006.01)

(86) International application number:
**PCT/KR2015/014161**

(87) International publication number:
**WO 2017/010636 (19.01.2017 Gazette 2017/03)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **10.07.2015 KR 20150098645
24.07.2015 KR 20150104878**

(71) Applicant: **Posco**
**Pohang-si, Gyeongsangbuk-do 37859 (KR)**

(72) Inventors:
- **JEONG, Hyunju**
  **Hwaseong-si**
  **Gyeonggi-do 18303 (KR)**
- **LEE, Jong-Seog**
  **Incheon 21986 (KR)**
- **LEE, Jeong-Hee**
  **Incheon 22009 (KR)**

(74) Representative: **Zech, Stefan Markus**
**Meissner Bolte Patentanwälte**
**Rechtsanwälte Partnerschaft mbB**
**Postfach 86 06 24**
**81633 München (DE)**

(54) **COLOR-TREATED SUBSTRATE AND COLOR TREATMENT METHOD THEREFOR**

(57)    The present invention relates to a color-treated substrate and a substrate color treatment method therefor. The color-treated substrate according to the present invention includes a carbon layer and can thus implement the high hardness and various colors of a metal substrate, and includes an interlayer containing metal hydroxide to enhance contacting force between the carbon layer and the metal substrate, and thus has excellent durability and excellent corrosion resistance.

[Fig.1]

| Carbon layer |
|:---:|
| Interlayer |
| Metal substrate |

**Description**

[Technical Field]

The present invention relates to a color-treated substrate and a substrate color treatment method therefor.

[Background Art]

Magnesium, which is a metal belonging to ultra-lightweight metals among practical metals, is environmentally friendly, but has a problem in that it is difficult to realize the texture and various colors of a metal. Also, magnesium, which is a metal having the lowest electro potential, is extremely active, and thus is very rapidly corroded in air or a solution when a surface thereof is not treated. Therefore, there are many difficulties in applying magnesium to industry.
Recently, as the magnesium industry has attracted great attention due to the trend toward a low weight throughout industry, metal-textured exterior materials have become a trend in materials for an electrical and electronic part such as a mobile phone case, and thus research is being actively conducted on improvement of such a problem of magnesium.
For example, Korean Unexamined Patent Publication No. 2011-0016750 disclosed a PVD-sol gel method in which a surface of a substrate made of a magnesium alloy is dry-coated with a metal-containing material and then sol-gel-coated to realize a metal texture and ensure corrosion resistance. Also, US Patent Publication No. 2011-0303545 disclosed an anodizing method in which glossiness is imparted to a surface of a substrate including magnesium using chemical polishing, and a color of a substrate surface is developed by anodizing the substrate in a basic electrolyte in which a pigment or a dye is dissolved.
However, the PVD-sol gel method may realize a metal texture on a surface of a substrate, but the metal texture is not a unique metal texture of magnesium, and it is difficult to realize various colors. Also, when a color is developed using the anodizing method, an opaque oxide film is formed on a substrate surface, a unique metal texture of a metal is not easily realized, and durability is low due to low hardness.
Therefore, in order to practically use a substrate including magnesium, there is an urgent need to develop a technology that may realize a desired color and a unique metal texture on a surface of the substrate without use of a dye by chemically, electrochemically, or physically treating the surface, and simultaneously may improve the durability of the substrate by improving low hardness of the substrate.

[Disclosure]

[Technical Problem]

The present invention is designed to solve the problems of the prior art, and it is an aspect of the present invention to provide a color-treated substrate in which various colors are uniformly realized on a surface while texture and glossiness of a metal are maintained, and durability and corrosion resistance of the substrate are improved.
It is another aspect of the present invention to provide a method of color-treating the substrate.

[Technical Solution]

In order to accomplish the above objectives, according to an embodiment of the present invention, there is provided a color-treated substrate which includes a metal substrate; an interlayer formed on the metal substrate and containing a metal hydroxide; and a carbon layer formed on the interlayer.
In addition, according to another embodiment of the present invention, there is provided a method of color-treating a substrate, which includes forming an interlayer containing a metal hydroxide on a metal substrate; and forming a carbon layer on the interlayer.

[Advantageous Effects]

A color-treated substrate according to the present invention includes a carbon layer and thus can realize high hardness and various colors of a metal substrate, and includes an interlayer containing a metal hydroxide to enhance adhesion between the carbon layer and the metal substrate, and thus can have excellent durability and excellent corrosion resistance.

[Description of Drawings]

FIG. 1 is a cross-sectional view of a structure of a substrate which is color-treated at one surface thereof according to the present invention.

FIG. 2 includes transmission electron microscopy (TEM) analysis images of a color-treated substrate according to an embodiment of the present invention.

FIG. 3 includes images obtained by photographing a surface after corrosion resistance of a metal substrate on which an interlayer is formed is evaluated according to another embodiment of the present invention.

FIG. 4 includes images obtained by photographing surfaces after corrosion resistances of a substrate including an interlayer containing a metal hydroxide and a substrate including a chromium layer as a buffer layer are evaluated according to still another embodiment of the present invention.

[Best Mode]

As the present invention allows for various changes and a variety of embodiments, particular embodiments will be illustrated in the drawings and described in detail in the detailed description.

However, this is not intended to limit the present invention to specific embodiments, and it should be appreciated that all changes, equivalents, or substitutes within the spirit and technical scope of the present invention are included in the present invention.

In the present invention, it should be appreciated that the term "include" or "have" is merely intended to indicate that features, numbers, steps, operations, components, parts, or combinations thereof are present, and not intended to exclude the possibility that one or more other features, numbers, steps, operations, components, parts, or combinations thereof will be present or added.

Also, drawings attached to the present specification should be understood to be magnified or reduced for the sake of convenience of the description.

Hereinafter, the present invention will be described with reference to the accompanying drawings. The same reference numerals are used for the same or corresponding component even in different drawings, and redundant description thereof will be omitted.

The term "color coordinates" used herein refer to coordinates in the CIELAB color space which represent color values defined by the Commission International de l'Eclairage (CIE), and any position in the CIELAB color space may be expressed as three coordinate values $L^*$, $a^*$, and $b^*$.

Here, an $L^*$ value represents brightness. $L^*=0$ represents a black color, and $L^*=100$ represents a white color. Moreover, an $a^*$ value represents whether a color at a corresponding color coordinate leans toward a pure magenta color or a pure green color, and a $b^*$ value represents whether a color at a corresponding color coordinate leans toward a pure yellow color or a pure blue color.

Specifically, the $a^*$ value ranges from $-a$ to $+a$, the maximum $a^*$ value ($a^*$ max) represents a pure magenta color, and the minimum $a^*$ value ($a^*$ min) represents a pure green color. For example, when an $a^*$ value is negative, the corresponding color leans toward a pure green color, and when an $a^*$ value is positive, the corresponding color leans toward a pure magenta color. This indicates that, when $a^*=80$ is compared with $a^*=50$, $a^*=80$ represents a color which is closer to a pure magenta color than $a^*=50$. Furthermore, the $b^*$ value ranges from $-b$ to $+b$, the maximum $b^*$ value ($b^*$ max) represents a pure yellow color, and the minimum $b^*$ value ($b^*$ min) represents a pure blue color. For example, when a $b^*$ value is positive, a color leans toward a pure yellow color, and when a $b^*$ value is negative, a color leans toward a pure blue color. This indicates that, when $b^*=50$ is compared with $b^*=20$, $b^*=50$ represents a color which is closer to a pure yellow color than $b^*=20$.

In addition, the term "color deviation" or "color coordinate deviation" used herein refers to a distance between two colors in the CIELAB color space. That is, a longer distance denotes a larger difference in color, and a shorter distance denotes a smaller difference in color. This may be expressed as $\Delta E^*$ represented by Equation 1 below:

[Equation 1]

$$\triangle E^* = \sqrt{(\triangle L^*)^2 + (\triangle a^*)^2 + (\triangle b^*)^2}$$

Furthermore, a unit "T" used herein represents a thickness of a metal substrate, and may be the same as a unit "mm".

In addition, the term "inclination angle ($\alpha$)" used herein refers to the smallest angle among angles formed by a surface of a metal substrate or a surface horizontal to a surface of a metal substrate and any axis along the longer dimension of a crystal.

Additionally, the term "diamond-like carbon layer (DLC layer)" used herein refers to an amorphous carbon layer not having a crystal structure, and refers to a film, a thin film, or a coating layer including sp$^1$, sp$^2$, and sp$^3$ hybridized carbon atoms.

The present invention relates to a color-treated substrate and a substrate color treatment method therefor.

Conventionally, a PVD-sol gel method, an anodizing method, and the like, in which a surface of a material is coated with a metal-containing material, a pigment, or the like, are known as a method of realizing a color in materials including magnesium. However, these methods may reduce the durability of a substrate. Also, it is difficult to realize a color uniformly on a material surface, and reliability is not satisfied because a coating layer that has been applied is easily peeled off. Particularly, these methods do not realize a unique metal texture of a metal and may also not be easily applicable in the fields of exterior materials for construction, interior materials for automobile, and, particularly, materials for an electrical and electronic part such as a frame for a mobile product due to low corrosion resistance and durability of a substrate.

In order to overcome the above problems, the present invention provides a color-treated substrate and a substrate color treatment method therefor.

The color-treated substrate according to the present invention includes a carbon layer and thus can realize high hardness and various colors of a metal substrate, and includes an interlayer containing a metal hydroxide to enhance adhesion between the carbon layer and the metal substrate, and thus can have excellent durability and excellent corrosion resistance.

Hereinafter, the present invention will be described in more detail.

According to an embodiment of the present invention, there is provided a color-treated substrate which includes a metal substrate; an interlayer formed on the metal substrate and containing a metal hydroxide; and a carbon layer formed on the interlayer.

The color-treated substrate according to the present invention may have a structure in which the interlayer containing a metal hydroxide and the carbon layer are sequentially laminated on the metal substrate. Such a laminated structure may be formed on one surface or both surfaces of the metal substrate.

The color-treated substrate includes the carbon layer on a surface of the metal substrate so as to improve the hardness of the metal substrate and uniformly realize various colors by scattering and refracting or absorbing light incident on a surface.

Hereinafter, each component of the color-treated substrate according to the present invention will be described in more detail.

First, the metal substrate serves to determine the basic structure and properties of the color-treated substrate, and may be a state before the color-treated substrate is color-treated.

The metal substrate is not particularly limited in type or form thereof as long as it can be used in a frame in the field of materials for an electrical and electronic product. As one example, a magnesium substrate in which magnesium is used as a main component may be used as the metal substrate; alternatively, in some cases, stainless steel including magnesium dispersed on a surface thereof may be used. Here, the phrase "a substance is used as a main component" means that the substance is included in an amount of 90 parts by weight or more, 95 parts by weight or more, 96 parts by weight or more, 97 parts by weight or more, 98 parts by weight or more, or 99 parts by weight or more with respect to the total weight of the substrate. For example, a substrate using magnesium as a main component may include 95 parts by weight of magnesium and 5 parts by weight of metal elements, wherein the metal elements may be one or more metals selected from the group consisting of aluminum (Al), copper (Cu), zinc (Zn), cadmium (Cd), and nickel (Ni).

Next, the carbon layer serves to realize various colors on a surface by scattering and refracting or absorbing light incident on the metal substrate, and improve hardness of the metal substrate.

As one example, in the color-treated substrate according to the present invention, the average color coordinate deviations ($\Delta L^*$, $\Delta a^*$, and $\Delta b^*$) of any three points included in an arbitrary area (1 cm (width)$\times$1 cm (length)) on the carbon layer may satisfy one or more conditions of $\Delta L^*<0.5$, $\Delta a^*<0.6$, and $\Delta b^*<0.6$. Particularly, the color-treated substrate according to the present invention may satisfy two or more, more particularly, all of the above conditions.

In an embodiment of the present invention, an interlayer containing magnesium hydroxide and a carbon layer were sequentially formed on a magnesium substrate, and then the CIE color coordinates corresponding to any three points included in an arbitrary area on the carbon layer were measured. As a result, color coordinate deviations were $0.05 \leq \Delta L^*<0.20$, $0.05<\Delta a^*<0.30$, and $0.1<\Delta b^*<0.55$, all of which satisfy the above conditions. Also, it was confirmed that a $\Delta E^*$ value derived from the measured values was $0.30 \leq \Delta E^*<0.60$, indicating a very small color coordinate deviation. This means that a color of the color-treated substrate according to the present invention is uniform.

In addition, a color to be realized may be adjusted in accordance with an average thickness of the carbon layer according to the present invention. Specifically, when the carbon layer has an average thickness greater than 1 $\mu$m, light incident on a surface of the color-treated substrate is absorbed, and thus a black color which is the original color of the carbon layer may be realized. Also, when the carbon layer has an average thickness of 1 $\mu$m or less, a carbon layer in the form of a transparent thin film is formed to induce scattering and refraction of light incident on a surface, and thus various colors other than black may be realized on a surface of the metal substrate.

In this case, the carbon layer may have an average thickness of 5 nm to 10 $\mu$m, 50 nm to 900 nm, 100 nm to 700 nm, 100 nm to 500 nm, 100 nm to 350 nm, 5 nm to 1$\mu$m, 500 nm to 1 $\mu$m, 1 $\mu$m to 2 $\mu$m, 3 $\mu$m to 4 $\mu$m, 5 $\mu$m to 6 $\mu$m, 1 $\mu$m to 6 $\mu$m, or 2 $\mu$m to 8 $\mu$m. In the present invention, the average thickness is adjusted within the above range so that various colors may be realized economically and damage to the carbon layer such as cracking caused by an excessive average thickness may be prevented.

Furthermore, the carbon layer is a layer consisting of carbon atoms, and particularly, may be a layer consisting of carbon atoms and having $sp^3$ bonds or a layer consisting of a carbon nanostructure such as graphene, carbon nanotubes, or the like and having $sp^2$ bonds. Preferably, the carbon layer is a diamond-like carbon layer (DLC layer) with an amorphous structure having a combination of $sp^1$, $sp^2$, and $sp^3$ hybridized bonds. Since the DLC layer exhibits high hardness like diamond, hardness may be effectively improved without a change in properties of the metal substrate.

Next, the interlayer is a buffer layer formed between the metal substrate and the carbon layer, and serves to enhance adhesion between the metal substrate and the carbon layer, improve the durability of the metal substrate, and simultaneously prevent corrosion.

As one example, the corrosion resistance of a metal substrate on which an interlayer having an average thickness of about 100 nm or less is formed may be significantly improved without a change in a unique color of a metal caused by the interlayer.

Specifically, the average CIE color coordinates of any three points included in an arbitrary area (1 cm (width)$\times$1 cm (length)$\times$0.4 T) on a magnesium substrate on which an interlayer (average thickness: about 100 nm or less) was formed were measured. As a result, it was confirmed that the average CIE color coordinates of the surface-treated magnesium substrate were 76.10$\leq$*L$\leq$76.30, -0.70$\leq$*a$\leq$-0.80, and 5.10$\leq$*b$\leq$5.35. Also, it was confirmed that a deviation between the above CIE color coordinates and CIE color coordinates of a magnesium substrate on which an interlayer was not formed was less than 5%, particularly, less than 4%. This means that, when an interlayer having an average thickness of about 100 nm or less is formed alone on a surface of a magnesium substrate, a color is hardly changed.

In addition, when 5 wt% salt water was uniformly sprayed onto a magnesium substrate on which an interlayer (average thickness: about 100 nm or less) was formed and a magnesium substrate on which an interlayer was not formed using a salt spray tester (SST) at 35 °C and then the magnesium substrates were maintained at 35 °C for 240 hours, areas accounting for about 5% or less, particularly, 4% or less, 3% or less, 2% or less, or 1% or less of the entire surface area of the magnesium substrate on which an interlayer is formed were corroded. However, in the case of the magnesium substrate on which an interlayer was not formed, about 50% or more of the entire surface area of the substrate was not uniform and was discolored.

As another example, when the color-treated substrate according to the present invention including both an interlayer and a carbon layer was subjected to a salt spray test for 24 hours, areas accounting for 5% or less, 4% or less, 3% or less, 2% or less, or 1% or less of the entire surface area of the substrate were corroded due to improved corrosion resistance of a metal substrate.

Specifically, 5 wt% salt water was uniformly sprayed onto the substrate according to the present invention including an interlayer and a substrate including a chromium layer as a buffer layer using a salt spray tester (SST) at 35 °C, and then the magnesium substrates were maintained at 35 °C for 24 hours. Afterward, surfaces thereof were observed with the naked eye. As a result, it was confirmed that, since the color-treated substrate according to the present invention included an interlayer on the surface thereof, 1% or less of the entire surface area of the substrate was deformed due to corrosion caused by salt water. However, it was confirmed that, since a surface of the substrate including a chromium layer as a buffer layer was corroded due to salt water, about 80% or more of the entire surface area of the substrate was not uniform and was deformed. From these results, it can be seen that the interlayer according to the present invention has a superior effect of enhancing adhesion between a metal substrate and a carbon layer, compared to a chromium layer conventionally used as a buffer layer of a diamond-like carbon layer, which may prevent the corrosion of a metal substrate.

In this case, the interlayer may include a metal hydroxide derived from a metal substrate, wherein the metal hydroxide may include one or more metals selected from the group consisting of Mg, Ti, Al, Cu, Zn, Cd, Mn, and Ni. Specifically, the metal hydroxide may be magnesium hydroxide ($Mg(OH)_2$).

Also, the interlayer may have an average thickness of 5 nm to 500 nm, particularly, 10 nm to 90 nm, 20 nm to 80 nm, 20 nm to 50 nm, 10 nm to 100 nm, 50 nm to 200 nm, 100 nm to 300 nm, 50 nm to 150 nm, 200 nm to 400 nm, 150 nm to 350 nm, or 300 nm to 500 nm.

In addition, according to another embodiment of the present invention, there is provided a method of color-treating a substrate, which includes forming an interlayer containing a metal hydroxide on a metal substrate; and forming a carbon layer on the interlayer.

The method of color-treating a substrate according to the present invention includes sequentially and uniformly laminating an interlayer and a carbon layer on a metal substrate so that excellent hardness and various colors of the metal substrate may be realized, and corrosion resistance of the metal substrate may be improved by enhancing adhesion between the metal substrate and the carbon layer.

In this case, the formation of an interlayer may be performed by any method without particular limitation as long as it is a method of coating a metal substrate with a metal hydroxide.

As one example, the interlayer may be formed by immersing a metal substrate in an alkaline aqueous solution in which 1 wt% to 20 wt% of NaOH, KOH, or the like is dissolved and/or water. Here, a temperature of the water and/or alkaline aqueous solution may be 30 °C to 150 °C, particularly, 50 °C to 140 °C or 90 °C to 110 °C. Also, the immersion may be performed for 1 minute to 200 minutes, particularly, 5 minutes to 30 minutes, 30 minutes to 100 minutes, 30 minutes to 120 minutes, or 100 minutes to 150 minutes. In the present invention, the metal substrate is immersed under the above conditions so that metal hydroxide crystals having an average inclination angle of 45° or higher with respect to a substrate surface may be formed on a surface of the metal substrate. Since the crystals thus formed come in contact with each other to form a network structure, a surface area increases, and thus adhesion between a metal substrate and a carbon layer, may be enhanced.

In addition, the formation of a carbon layer may be performed by any method without particular limitation as long as it is a method commonly used in formation of a carbon thin film in the art. As one example, the formation of a carbon layer may be performed by an ion plating method, a sputtering method, a high-frequency plasma method, an arc method, a plasma deposition method, or a chemical vapor deposition method such as plasma-assisted chemical vapor deposition (PACVD). Specifically, the carbon layer according to the present invention may be formed by a chemical vapor deposition method.

In the chemical vapor deposition method, the deposition may be performed at a temperature of 200 °C to 1,000 °C, particularly, 200 °C to 400 °C, 300 °C to 600 °C, 400 °C to 800 °C, or 750 °C to 900 °C. In the present invention, a condition for the chemical vapor deposition is adjusted within the above range so that a carbon layer with an amorphous structure having a combination of $sp^1$, $sp^2$, and $sp^3$ hybridized bonds may be uniformly formed on an interlayer.

Meanwhile, the method of color-treating a substrate according to the present invention may further include one or more of pre-treating a surface of the metal substrate before the formation of the interlayer; and forming a clear layer on the formed carbon layer after the formation of the carbon layer.

In the pre-treatment, a surface is washed with an alkaline cleaning solution to eliminate residual contaminants or polish the surface before an interlayer is formed on a metal substrate. Here, the alkaline cleaning solution is not particularly limited as long as it is commonly used to wash a surface of a metal, a metal oxide, or a metal hydroxide in the art. Also, the polishing may be performed by buffing, polishing, blasting, electropolishing, or the like, but the present invention is not limited thereto. In the pre-treatment, contaminants, scale, or the like present on a surface of the metal substrate may be eliminated, and adhesion between a magnesium substrate and an interlayer formed on the substrate may also be enhanced by a change in surface energy and/or conditions of the surface, particularly, a microstructure of the surface.

In addition, with the formation of a clear layer, the abrasion resistance and/or scratch resistance of a surface of a color-treated substrate, that is, a carbon layer, are/is improved. Here, the clear layer is not particularly limited as long as it does not change a color realized by a carbon layer and is commonly used in the art. For example, the clear layer is a ceramic coating, a polymer coating, or the like which has excellent light transmittance.

[Modes of the Invention]

Hereinafter, the present invention will be described in more detail according to embodiments and experimental example.

However, the following embodiment examples and experimental example are merely presented to exemplify the present invention, and the content of the present invention is not limited to the following embodiment examples and experimental example.

**Preparation Examples 1 and 2.**

A magnesium substrate with a size of 1 cm×1 cm×0.4 T was immersed in an alkaline cleaning solution for degreasing, and the substrate thus degreased was immersed in a 10 wt% NaOH aqueous solution at 95 °C for 10 minutes. Afterward, the resulting substrate was rinsed with distilled water and dried in a drying oven to obtain a magnesium substrate on which an interlayer was formed.

The CIE color coordinates of the magnesium substrate on which an interlayer was formed and a degreased magnesium substrate on which an interlayer was not formed were measured. In this case, the CIE color coordinates were determined by selecting three arbitrary points A to C in an arbitrary area (1 cm (width)×1 cm (length)) on the substrate and measuring the color coordinates corresponding to the selected points in a CIE color space to calculate an average color coordinate. In this case, a color coordinate deviation ($\Delta E^*$) was derived from Equation 1 below, and an average value thereof was obtained from the values of the color coordinate deviation thus derived.

As a result, it was confirmed that the average CIE color coordinates of the magnesium substrate on which an interlayer was formed were 76.10≤*L≤76.30, - 0.70≤*a≤-0.80, and 5.10≤*b≤5.35, and the average CIE color coordinates of the magnesium substrate on which an interlayer was not formed were 76.60≤*L≤76.90, - 0.70≤*a≤-0.80, and 5.10≤*b≤5.50.

[Equation 1]

$$\triangle E^* = \sqrt{(\triangle L^*)^2 + (\triangle a^*)^2 + (\triangle b^*)^2}$$

[Table 1]

|  | Formation of interlayer | Arbitrary point | L* | a* | b* |
|---|---|---|---|---|---|
| Preparation Example 1 | ○ | Point A | 76.29 | -0.77 | 5.17 |
|  |  | Point B | 76.24 | -0.74 | 5.32 |
|  |  | Point C | 76.11 | -0.76 | 5.28 |
|  |  | Average value | 76.21 | -0.76 | 5.26 |
| Preparation Example 2 | × | Point A | 76.70 | -0.75 | 5.17 |
|  |  | Point B | 76.68 | -0.73 | 5.32 |
|  |  | Point C | 76.88 | -0.75 | 5.41 |
|  |  | Average value | 76.75 | -0.74 | 5.30 |

**Examples 1 to 4.**

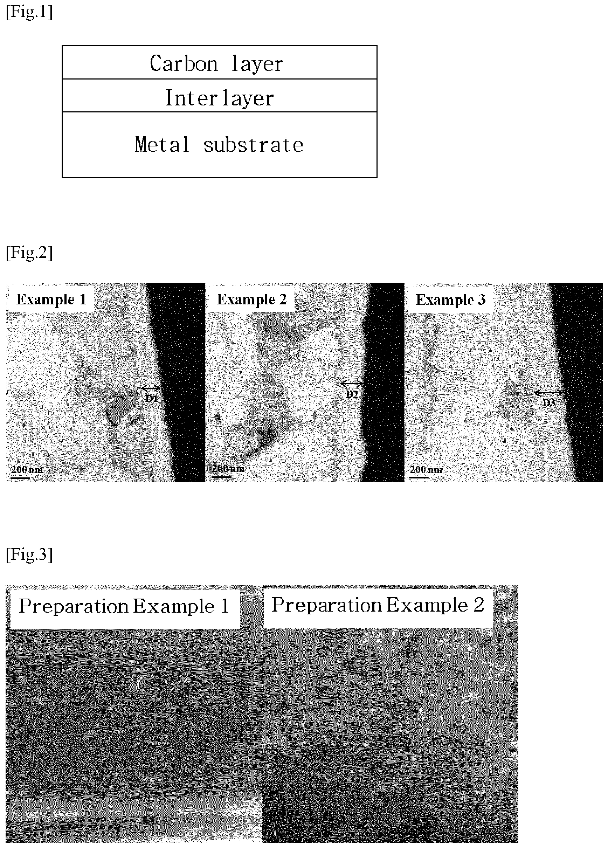

A magnesium substrate with a size of 6 cm (length)×6 cm (width)×0.4 T was immersed in an alkaline cleaning solution for degreasing, and the substrate thus degreased was immersed in 100 °C distilled water for 40 minutes to form an interlayer (average thickness: about 37±1.5 nm) containing magnesium hydroxide ($Mg(OH)_2$) as a metal hydroxide. The substrate on which the interlayer was formed was dried in a drying oven at 80 °C for 30 minutes, and fixed in a chemical vapor deposition device. Afterward, a diamond-like carbon layer (DLC layer) was deposited at 80 °C under 10 mTorr using hydrogen gas, oxygen gas, and methane gas as raw material gas to obtain a color-treated substrate. The color-treated substrate thus obtained was subjected to a transmission electron microscopy (TEM) analysis to measure an average thickness of the deposited carbon layer. The result thereof is shown in FIG. 2 and Table 2 below.

[Table 2]

|  | Average thickness of carbon layer |
|---|---|
| Example 1 | 200±5 nm |
| Example 2 | 228±5 nm |
| Example 3 | 300±5 nm |
| Example 4 | 3.0±0.1 μm |

**Comparative Example 1.**

A magnesium substrate with a size of 6 cm (length)×6 cm (width)×0.4 T was immersed in an alkaline cleaning solution for degreasing, and the substrate thus degreased was fixed in a dry deposition device. Afterward, a chromium layer (average thickness: about 40±2 nm) and a DLC layer (average thickness: 1 μm) were sequentially laminated using a RF/DC sputtering method under a temperature of 300 °C to obtain a color-treated substrate including the chromium layer as a buffer layer.

**Experimental Example 1.**

In order to evaluate the realized color and color uniformity of the color-treated substrate according to the present invention, an experiment was performed as follows.

Color development of each of the color-treated substrates according to Examples 1 to 4 was evaluated with the naked eye. Also, the average color coordinate deviation was determined by selecting three arbitrary points A to C on a surface of each of the color-treated substrates according to Examples 1 and 3 and measuring the color coordinates corresponding to the selected points in a CIE color space. In this case, the color coordinate deviation ($\Delta E^*$) was derived from Equation 1 below, the result of which is shown in Table 3.

[Equation 1]

$$\Delta E^* = \sqrt{(\Delta L^*)^2 + (\Delta a^*)^2 + (\Delta b^*)^2}$$

[Table 3]

|  | Three points | L* | a* | b* | ΔL* | Δa* | Δb* | ΔE* |
|---|---|---|---|---|---|---|---|---|
| Example 1 | A | 50.97 | -17.60 | 9.56 | - | - | - | - |
|  | B | 50.87 | -17.67 | 9.23 | 0.10 | 0.07 | 0.33 | 0.3529 |
|  | C | 50.85 | -17.73 | 9.28 | 0.12 | 0.13 | 0.28 | 0.3312 |
| Example 3 | A | 42.24 | -14.58 | -4.28 | - | - | - | - |
|  | B | 42.29 | -14.29 | -4.42 | 0.05 | 0.29 | 0.14 | 0.3259 |
|  | C | 42.24 | -14.45 | -4.82 | 0 | 0.13 | 0.54 | 0.5554 |

As a result, it can be confirmed that the color of a surface was uniformly developed in the case of the substrates according to Examples 1 to 4 which include magnesium as a main component. Specifically, it was confirmed with the naked eye that the color was uniformly developed into green, yellow, blue green, and black, respectively, in the case of the substrates according to Examples 1 to 4.

In addition, referring to Table 3, it can be seen that the color of the color-treated substrate in which an interlayer and a carbon layer were sequentially laminated on a magnesium substrate was uniformly realized. Specifically, the color coordinate deviations of any three points on the substrates according to Examples 1 and 3 were $0.05 \leq \Delta L^* < 0.20$, $0.05 < \Delta a^* < 0.30$, and $0.1 < \Delta b^* < 0.55$. Also, it was confirmed that the color-treated substrates exhibited a color coordinate deviation of $0.3 < \Delta E^* < 0.6$, indicating that the deviation of realized colors was small.

From these results, it can be seen that the color-treated substrate according to the present invention has a structure in which an interlayer and a carbon layer were uniformly and sequentially laminated on a metal substrate so that the color of a surface may be uniformly realized.

**Experimental Example 2.**

In order to evaluate the corrosion resistance of a magnesium substrate on which an interlayer was formed, an experiment was performed as follows.

To each of the magnesium substrate according to Preparation Example 1 on which an interlayer was not formed and the magnesium substrate according to Preparation Example 2 on which an interlayer was formed, 5 wt% salt water was uniformly sprayed using a salt spray tester (SST) at 35 °C, and a surface of the substrate after 240 hours had elapsed was evaluated with the naked eye. The result thereof is shown in FIG. 3.

Referring to FIG. 3, it was confirmed that a corroded area in the magnesium substrate on which an interlayer was formed accounted for about 1% or less of the entire surface area of the substrate, indicating that the substrate did not have a deformed surface, was not discolored, and was uniform. On the other hand, the magnesium substrate on which an interlayer was not formed was corroded due to salt water, and thus about 85% of the entire surface area of the substrate was not uniform and was discolored.

From these results, it can be seen that, in the case of the color-treated metal substrate according to the present invention, when an interlayer is formed, the corrosion resistance of the metal substrate is improved.

**Experimental Example 3.**

In order to evaluate the corrosion resistance of the color-treated substrate according to the present invention, an experiment was performed as follows.

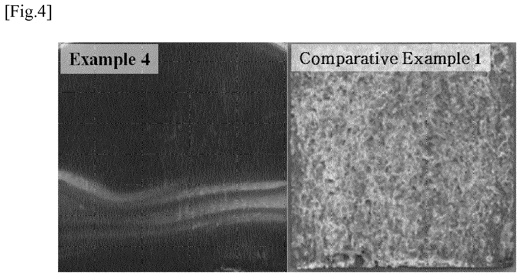

To each of the substrates according to Example 4 and Comparative Example 1, 5 wt% salt water was uniformly sprayed using a salt spray tester (SST) at 35 °C, and the substrates were maintained at 35 °C for 24 hours. Afterward, a surface thereof was evaluated with the naked eye, the result of which is shown in FIG. 4.

Referring to FIG. 4, it can be seen that the color-treated substrate according to the present invention exhibited an improvement in corrosion resistance. Specifically, the substrate according to Example 4, in which an interlayer containing magnesium hydroxide ($Mg(OH)_2$) and a carbon layer were sequentially laminated on a metal substrate, was not corroded even after salt water was sprayed, and a corroded area in the substrate accounted for about 1% or less of the entire surface area of the substrate. On the other hand, it can be confirmed that, in the case of the substrate according to Comparative Example 1 including a chromium layer as a buffer layer, salt water penetrated into a crack occurring between a metal substrate and a carbon layer, and thus about 80% or higher of the entire surface area of the substrate was nonuniformly corroded.

From these results, it can be seen that the interlayer according to the present invention has a superior effect of enhancing adhesion between a metal substrate and a carbon layer, compared to a chromium layer conventionally used as a buffer layer of a diamond-like carbon layer, which can prevent the corrosion of a metal substrate.

Therefore, in the color-treated substrate according to the present invention, an interlayer containing a metal hydroxide and a carbon layer may be sequentially and uniformly formed on a metal substrate to realize various colors in accordance with a thickness of a carbon layer while the unique glossiness and texture of a metal substrate are maintained. Also, since hardness of the substrate, adhesion between the metal substrate and the carbon layer, and corrosion resistance of the metal substrate are excellent, the color-treated substrate according to the present invention may be beneficially used in the fields of exterior materials for construction, interior materials for automobile, and, particularly, materials for an electrical and electronic part such as a frame for a mobile product, which use metal materials.

[Industrial Applicability]

A color-treated substrate according to the present invention includes a carbon layer and thus can realize high hardness and various colors of a metal substrate, and has excellent durability and corrosion resistance and thus can be beneficially used in the fields of exterior materials for construction, interior materials for automobile, and, particularly, materials for an electrical and electronic part such as a frame for a mobile product, which use metal materials.

**Claims**

1. A color-treated substrate comprising:

   a metal substrate;
   an interlayer formed on the metal substrate and containing a metal hydroxide; and
   a carbon layer formed on the interlayer.

2. The color-treated substrate of claim 1, wherein the metal substrate includes magnesium (Mg).

3. The color-treated substrate of claim 1, wherein the metal hydroxide includes one or more metals selected from the group consisting of Mg, Ti, Al, Cu, Zn, Cd, Mn, and Ni.

4. The color-treated substrate of claim 1, wherein the metal hydroxide is magnesium hydroxide ($Mg(OH)_2$).

5. The color-treated substrate of claim 1, wherein the carbon layer has an average thickness of 5 nm to 10 $\mu$m.

6. The color-treated substrate of claim 1, wherein the interlayer has an average thickness of 5 nm to 500 nm.

7. The color-treated substrate of claim 1, wherein, when the interlayer has an average thickness of 100 nm or less, average CIE color coordinates of any three points included in an arbitrary area (1 cm (width)$\times$1 cm (length)) on a corrosion-preventing layer satisfy one or more conditions of $76.0 \leq *L \leq 77.0$, $-0.4 \leq *a \leq -1.0$, and $5.0 \leq *b \leq 5.6$, and when a magnesium substrate (1 cm$\times$1 cm$\times$0.4 T) on which the corrosion-preventing layer is formed is subjected to a salt spray test (SST) for 240 hours, a corroded area accounts for 5% or less of an entire surface area of the substrate.

8. The color-treated substrate of claim 1, wherein, when a salt spray test (SST) is performed for 24 hours, a corroded area accounts for 5% or less of an entire surface area of the substrate.

9. The color-treated substrate of claim 1, wherein average color coordinate deviations ($\Delta L^*$, $\Delta a^*$, and $\Delta b^*$) of any three points included in an arbitrary area (1 cm (width)$\times$1 cm (length)) on the carbon layer satisfy one or more conditions of $\Delta L^*<0.5$, $\Delta a^*<0.6$, and $\Delta b^*<0.6$.

10. A method of color-treating a substrate comprising:

   forming an interlayer containing a metal hydroxide on a metal substrate; and
   forming a carbon layer on the interlayer.

11. The method of claim 10, wherein the interlayer is formed by immersing the metal substrate in water or an alkaline aqueous solution.

12. The method of claim 11, wherein the immersion is performed at 30 °C to 150 °C for 1 minute to 200 minutes.

13. The method of claim 10, wherein the carbon layer is formed by an ion plating method, a sputtering method, a high-frequency plasma method, an arc method, a plasma deposition method, or a chemical vapor deposition method.

14. The method of claim 10 further comprising one or more of:

   pre-treating a surface of the metal substrate before the formation of the interlayer; and
   forming a clear layer on the formed carbon layer after the formation of the carbon layer.

[Fig.1]

| Carbon layer |
|:---:|
| Interlayer |
| Metal substrate |

[Fig.2]

[Fig.3]

[Fig.4]

## INTERNATIONAL SEARCH REPORT

| International application No. |
|---|
| PCT/KR2015/014161 |

**A. CLASSIFICATION OF SUBJECT MATTER**

*C23C 28/00(2006.01)i, C23C 22/60(2006.01)i, C23C 22/64(2006.01)i, C23C 14/06(2006.01)i, C23C 14/34(2006.01)i, C23C 14/22(2006.01)i, C23C 14/32(2006.01)i, C23C 16/26(2006.01)i, C22C 23/00(2006.01)i*

According to International Patent Classification (IPC) or to both national classification and IPC

**B. FIELDS SEARCHED**

Minimum documentation searched (classification system followed by classification symbols)

C23C 28/00; C23C 22/57; C23C 14/06; C23C 14/12; C23C 14/00; C23C 22/46; C23C 14/34; C23C 14/02; C23C 16/26; C23C 22/60; C23C 22/64; C23C 14/22; C23C 14/32; C22C 23/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)

eKOMPASS (KIPO internal) & Keywords: color substrate, metal oxide, carbon layer, magnesium, decay resistance, adhesion, durability

**C. DOCUMENTS CONSIDERED TO BE RELEVANT**

| Category* | Citation of document, with indication, where appropriate, of the relevant passages | Relevant to claim No. |
|---|---|---|
| A | KR 10-2015-0076352 A (POSCO) 07 July 2015<br>See abstract, paragraphs [0027]-[0050] and claims 1, 6, 8. | 1-14 |
| A | KR 10-1252568 B1 (YOO, Heung Sang) 09 April 2013<br>See abstract, paragraphs [0011]-[0024] and claim 1. | 1-14 |
| A | KR 10-2015-0076354 A (POSCO) 07 July 2015<br>See abstract, paragraphs [0036]-[0077] and claims 1, 6. | 1-14 |
| A | JP 10-158838 A (KYOCERA CORP.) 16 June 1998<br>See abstract, paragraphs [0013]-[0026] and claims 1, 2. | 1-14 |
| A | KR 10-2009-0064670 A (RESEARCH INSTITUTE OF INDUSTRIAL SCIENCE & TECHNOLOGY) 22 June 2009<br>See abstract, claims 1-4 and figure 1. | 1-14 |

☐ Further documents are listed in the continuation of Box C.   ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 APRIL 2016 (07.04.2016) | **07 APRIL 2016 (07.04.2016)** |

| Name and mailing address of the ISA/KR | Authorized officer |
|---|---|
| Korean Intellectual Property Office<br>Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (January 2015)

INTERNATIONAL SEARCH REPORT
Information on patent family members

International application No.

**PCT/KR2015/014161**

| Patent document cited in search report | Publication date | Patent family member | Publication date |
|---|---|---|---|
| KR 10-2015-0076352 A | 07/07/2015 | KR 10-1543924 B1 | 12/08/2015 |
| | | KR 10-1543925 B1 | 12/08/2015 |
| | | KR 10-1543926 B1 | 12/08/2015 |
| | | KR 10-1584413 B1 | 11/01/2016 |
| | | KR 10-2015-0075765 A | 06/07/2015 |
| | | KR 10-2015-0076353 A | 07/07/2015 |
| | | KR 10-2015-0076354 A | 07/07/2015 |
| | | WO 2015-099496 A1 | 02/07/2015 |
| | | WO 2015-099498 A1 | 02/07/2015 |
| | | WO 2015-099501 A1 | 02/07/2015 |
| | | WO 2015-099503 A1 | 02/07/2015 |
| | | WO 2015-099505 A1 | 02/07/2015 |
| KR 10-1252568 B1 | 09/04/2013 | WO 2013-137520 A1 | 19/09/2013 |
| KR 10-2015-0076354 A | 07/07/2015 | KR 10-1543924 B1 | 12/08/2015 |
| | | KR 10-1543925 B1 | 12/08/2015 |
| | | KR 10-1543926 B1 | 12/08/2015 |
| | | KR 10-1584413 B1 | 11/01/2016 |
| | | KR 10-2015-0075765 A | 06/07/2015 |
| | | KR 10-2015-0076352 A | 07/07/2015 |
| | | KR 10-2015-0076353 A | 07/07/2015 |
| | | WO 2015-099496 A1 | 02/07/2015 |
| | | WO 2015-099498 A1 | 02/07/2015 |
| | | WO 2015-099501 A1 | 02/07/2015 |
| | | WO 2015-099503 A1 | 02/07/2015 |
| | | WO 2015-099505 A1 | 02/07/2015 |
| JP 10-158838 A | 16/06/1998 | JP 3515866 B2 | 05/04/2004 |
| KR 10-2009-0064670 A | 22/06/2009 | KR 10-1451412 B1 | 16/10/2014 |

Form PCT/ISA/210 (patent family annex) (January 2015)

**REFERENCES CITED IN THE DESCRIPTION**

**Patent documents cited in the description**

- KR 20110016750

- US 20110303545 A